# EUROPEAN PATENT APPLICATION

(11) **EP 2 416 358 A2**
(43) Date of publication of application: **08.02.2012**
(21) Application number: 11167603.7
(22) Date of filing: 26.05.2011
(51) Int. Cl.: H01L 23/522

(54) **Electronic device and method for fabricating the same, spiral inductor device and method for fabricating the same**

(30) Priority: 04.08.2010 TW 099126041
(71) Applicant: RichWave Technology Corp., Taipei City 114 (TW)
(72) Inventor: Chen, Ja-Hao, 114 Taipei (TW)
(74) Representative: 2K Patentanwälte Blasberg Kewitz & Reichel

(57) **Abstract**

The invention provides an electronic device and method for fabricating the same, and a spiral inductor device and method for fabricating the same. The electronic device includes a substrate and a conductive trace pattern formed on the substrate, wherein the conductive trace pattern has an opening to expose the substrate.

## Description

### CROSS REFERENCE TO RELATED APPLICATIONS

This Application claims priority of Taiwan Patent Application No. 099126041, filed on August, 4, 2010, the entirety of which is incorporated by reference herein.

### BACKGROUND OF THE INVENTION

### Field of the Invention

The present invention relates to an electronic device, and in particular relates to an electronic device with an opening.

### Description of the Related Art

Many digital and analog elements and circuits have been successfully applied to semiconductor integrated circuits. Such elements may include passive components, such as resistors, capacitors, or inductors. Typically, a semiconductor integrated circuit includes a silicon substrate. One or more dielectric layers are formed on the substrate, and one or more metal layers are formed in the dielectric layers or thereon. The metal layers may be employed to form on-chip elements, such as on-chip inductors, by current semiconductor technologies.

Conventionally, an on-chip inductor is formed on an insulating layer on a substrate, wherein the inductor is electrically connected to an external circuit by the conductive plugs, the conductive layers and the signal output/input conductive traces. A principle advantage of the planar spiral inductor device is an increased level of circuit integration due to the reduced number of off-chip circuit elements and the complex interconnections required thereby.

In spiral inductor devices, there are three factors to estimate the quality factor (Q value) of the inductor devices, including skin effect, substrate eddy current and coil eddy current.

To reduce the skin effect loss, spiral conductive traces are widened or thickened. To improve the substrate eddy current loss, use of a grounding metal shielding layer, interposed between the spiral conductive trace and the semiconductor substrate, has been proposed. However, there is currently no way to improve the coil eddy current loss.

Since the performance of the inductor devices is based on the Q value, there is a need to develop an inductor device so that the coil eddy current loss can be improved.

### BRIEF SUMMARY OF THE INVENTION

The invention provides an electronic device, comprising: a substrate; and a conductive trace pattern formed on the substrate, wherein the conductive trace pattern has an opening to expose the substrate.

The invention also provides a spiral inductor device, comprising: a substrate; and a spiral conductive trace pattern with at least one turn formed on the substrate, wherein the spiral conductive trace pattern has an opening to expose the substrate.

The invention also provides a method for fabricating an electronic device, comprising: providing a substrate; and forming a conductive trace pattern on the substrate, wherein the conductive trace pattern has an opening to expose the substrate.

The invention also provides a method for fabricating a spiral inductor device, comprising: providing a substrate; and forming a spiral conductive trace pattern on the substrate, wherein the spiral conductive pattern has an opening to expose the substrate.

A detailed description is given in the following embodiments with reference to the accompanying drawings.

### BRIEF DESCRIPTION OF THE DRAWING

For a more complete understanding of the present invention, and the advantages thereof, reference is now made to the following descriptions taken in conjunction with the accompanying drawings, in which:

Figure 1A shows a top-view schematic representation of an electronic device in accordance with an embodiment of the invention; and

Figure 1B-1C show a cross-sectional schematic representations of an electronic device in accordance with an embodiment of the invention;

Figure 1D shows a top-view schematic representation of an electronic device in accordance with an embodiment of the invention;

Figure 2A shows a top-view schematic representation of a spiral inductor device in accordance with an embodiment of the invention;

Figures 2B show a cross-sectional schematic representation of a spiral inductor device in accordance with an embodiment of the invention; and

Figures 2C shows a top-view schematic representation of a spiral inductor device in accordance with an embodiment of the invention.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

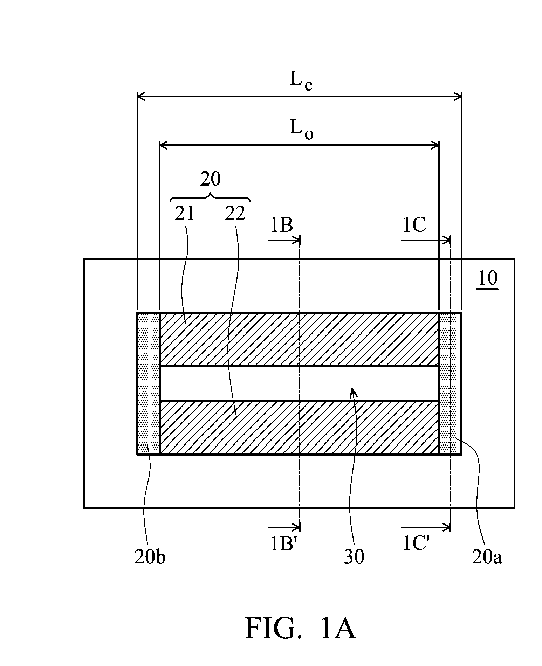

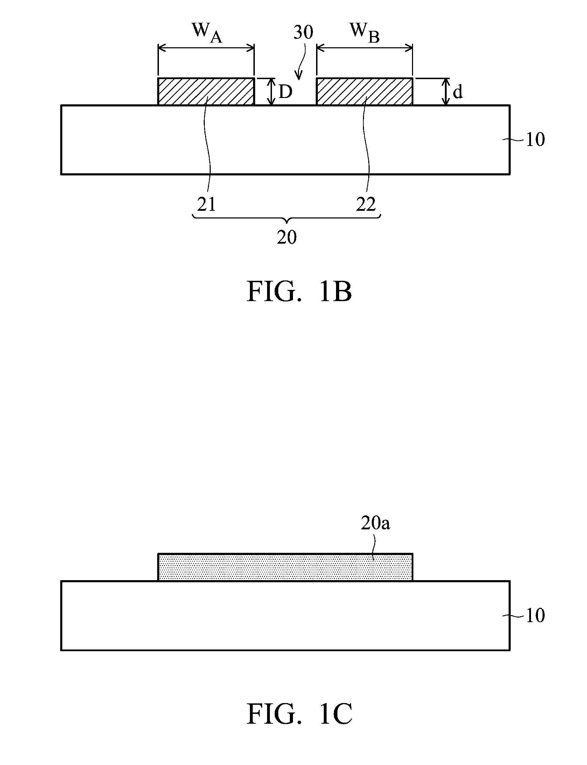

Refer to FIGS. 1A to 1C, in which FIG. 1A is a top view of an embodiment of an electronic device, FIG. 1B shows a cross section along 1B-1B' line shown in Fig. 1A, and FIG. 1C shows a cross section along 1C-1C' line shown in Fig. 1A.

Referring to FIG. 1A and FIG. 1B, the invention provides an electronic device, wherein an opening is formed in a conductive trace pattern of the electronic device to change the amplitude of the magnetic field of the electronic device. The electronic device comprises: a substrate 10; and a conductive trace pattern 20 formed on the substrate 10, wherein the conductive trace pattern 20 has an opening 30 to expose the substrate 10.

The substrate 10 may include a silicon substrate or other well-known semiconductor substrates. The substrate 10 may include various elements, such as transistors, resistors, or other well-known semiconductor elements. Moreover, the substrate 10 may also include other conductive layers (e.g. copper, aluminum or alloy thereof) and insulating layers (e.g. silicon oxide, silicon nitride or low-k dielectric materials). Hereinafter, to simplify the diagram, only a flat substrate is depicted.

The conductive trace pattern 20 is a single conductive trace, or a number of parallel or parallel conductive traces. The material of the conductive trace pattern 20 may comprise copper, aluminum or alloy thereof. The conductive trace pattern 20 has a first end 20a and a second end 20b to input/output signals. According to actual application needs, the first end 20a and the second end 20b separately connect to other interconnect structures (not shown in figures).

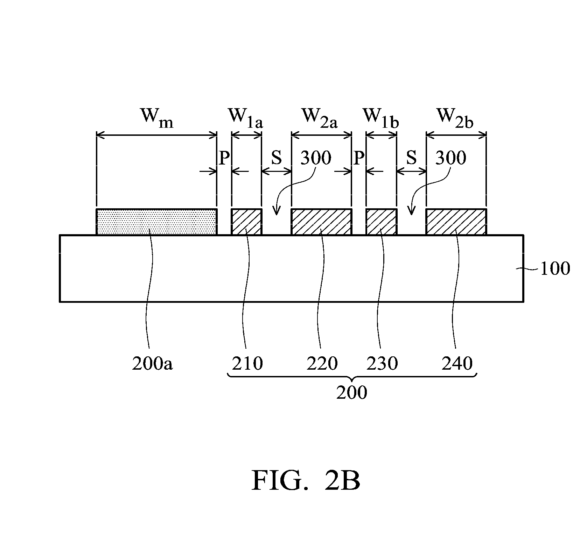

The opening 30 is formed in the conductive trace pattern 20 and the conductive trace pattern is divided into a first part 21 and a second part 22, wherein a width of the first part 21 may be larger, equal to or smaller than a width of the second part 22. Referring to FIG. 2B, the width W_{A} of the first part 21 is equal to the width W_{B} of the second part 22.

The opening 30 is extended from the first end 20a to the second end 20b. The opening 30 is extended from the top surface of the conductive trace pattern 20 down to the depth D which is the same as that of the thickness d of the conductive trace pattern 20. Thus, the substrate 10 below the opening 30 is exposed. Referring to FIG. 1C, note that the conductive trace pattern 20 is divided into the first part 21 and the second part 22, but the opening 30 does not pass through the first end 20a and second end 20b. Therefore, the first part 21 and the second part 22 electrically connect to each other by the first end 20a and the second end 20b.

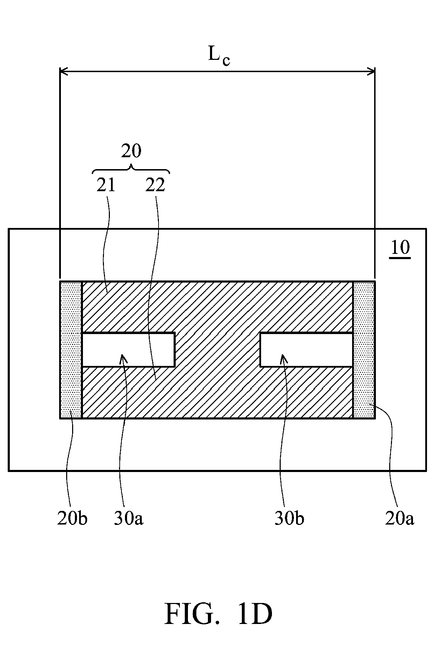

Additionally, the opening 30 comprises a continuous structure or a discontinuous structure, wherein the opening 30 is divided into a plurality of sections to form the discontinuous structure. Referring to FIG. 1A, the opening 30 is a continuous structure. Alternatively, in another embodiment, referring to FIG. 1D the opening 30 is a discontinuous structure which is divided into two sections 30a and 30b.

Moreover, referring to FIG. 1A, the opening 30 is formed along the conductive trace pattern 20, and a length Lₒ of the opening 30 is smaller than a length L_{c} of the conductive trace pattern 20. Furthermore, the conductive trace pattern 20 comprises an arc shape or a rectangular shape. In one embodiment, the conductive trace pattern 20 is a spiral conductive trace.

According to Ampere's Law, as current flows through the electronic device, magnetic field is produced by the current. And, as the magnetic field passes through the conductive trace, an unwanted eddy current is induced. Because the original current and the eddy current interact with each other, the performance of the electronic device is reduced. In order to solve the above problems, an opening is formed in the conductive trace pattern of the electronic device of the invention, so that the amplitude of the magnetic field is changed by adjusting the position of the opening. Thus, the current of the conductive trace pattern is uniformly distributed to improve the performance of the electronic device.

The electronic device of the invention may be an inductor or other passive electronic devices, such as a transmission line or an energy storage device. All electronic devices in which performance may be affected by the uneven current are within the scope of the invention. Note that according to the shape and length of the conductive trace pattern, the position of the opening may be adjusted by those skilled in the art to change the amplitude of the magnetic field of the conductive trace pattern.

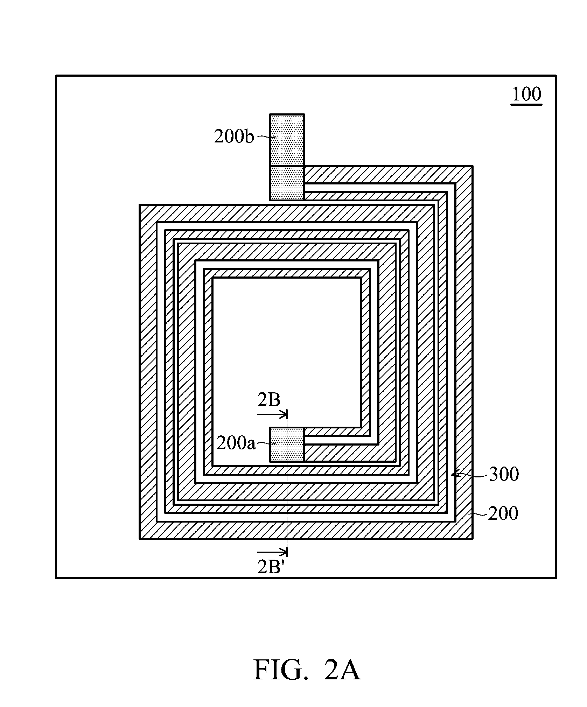

Refer to FIGS. 2A to 2B, in which FIG. 2A is a top view of an embodiment of a spiral inductor device, and FIG. 2B shows a cross section along 2B-2B' line shown in Fig. 2A.

Referring to FIG. 2A, the invention provides a spiral inductor device, which comprises: a substrate 100 and a spiral conductive trace pattern 200, wherein the spiral conductive trace pattern 200 is formed on the substrate 100 and has an opening 300. The material of the substrate 100 is the same as that of the first embodiment; thus, repeated description is omitted.

The spiral conductive trace pattern 200 has at least one turn and comprises an inner end 200a and an outer end 200b. All of the spiral conductive trace pattern 200 may substantially be in the same plane or not in the same plane. According to actual application needs, the first end 200a and second end 200b, separately connect to other interconnect structures (not shown in figures). In this embodiment, the spiral conductive trace pattern 200 extends from the outer end 200b to the inner end 200a clockwise. In other embodiment, the spiral conductive trace pattern 200 may extend counterclockwise. In FIG. 2A, the spiral conductive trace pattern 200 comprises 2.5 turns, but may comprises more turns as required.

The spiral conductive trace pattern 200 may comprise a circular, rectangular, hexagonal, octagonal or polygonal shape, and comprises a rectangular shape as shown in the preferred embodiment in FIG. 2A. The material of the spiral conductive trace pattern 200 may comprise copper, aluminum or alloy thereof.

The opening 300 extends from the inner end 200a to the outer end 200b. The opening 300 is extended from the top surface of the conductive trace pattern 200 down to the depth which is the same as that of the thickness of the conductive trace pattern 200. Thus, the substrate 100 below the opening 300 is exposed.

Referring to FIG. 2B, note that the opening 300 does not pass through the inner end 200a. Although the conductive trace pattern 200 is divided into two parts by the opening 300, the two parts still electrically connect to each other (by the inner end 200a and the outer end 200b).

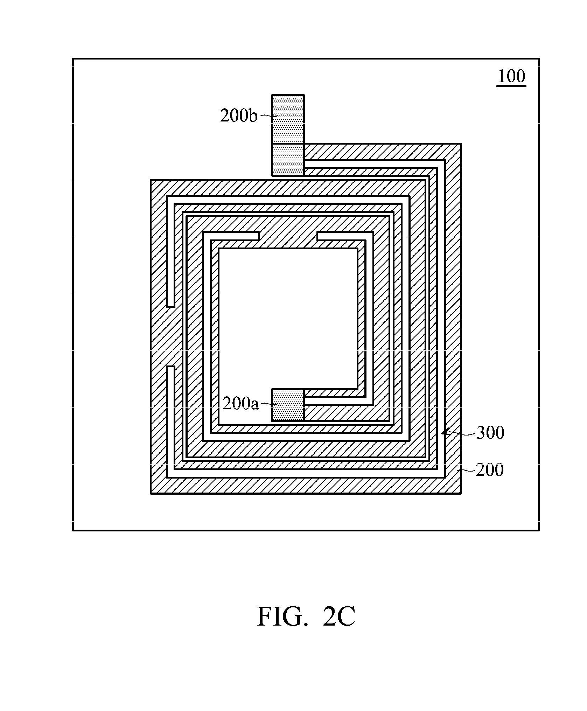

Moreover, the opening 300 is formed along the spiral conductive trace pattern 200, and a length of the opening 300 is smaller than a length of the spiral conductive trace pattern 200. Furthermore, the opening 300 comprises a continuous structure or a discontinuous structure, wherein the opening 300 is divided into a plurality of sections to form the discontinuous structure. Referring to FIG. 2A, the opening 300 is a continuous structure. Alternatively, in another embodiment, referring to FIG. 2C, the opening 300 is a discontinuous structure and the opening 30 is divided into three sections.

Referring to FIG. 2B, the spiral conductive trace pattern 200 has a width Wₘ, the pitches between neighboring turns of the spiral conductive trace pattern 200 has a value P, and the opening 300 has a width S. The spiral conductive trace pattern 200 is divided into a first part 210 (a width of W₁ₐ), 230 (a width of W_{1b}) and a second part 220 (a width of W₂ₐ), 240 (a width of W_{2b}) by the opening 300, wherein the first part 210, 230 is nearer to the inner end 200a than that of the second port 220, 240. The sum of the width (W₁ₐ, W_{1b}) of the first part, the width (W₂ₐ, W_{2b}) of the second part and the width (S) of the opening 300 is the width (Wₘ) of the spiral conductive trace pattern 200, and is represented as Wₘ = W_{1a,1b} + W_{2a,2b} + S.

In prior art, when the current flows through the adjacent coils of the inductor, the magnetic field is generated in the adjacent coils (according to Ampere's law). When the magnetic field passes through the adjacent coil, an eddy current surrounding the coil is produced. The uneven current distribution of the coils caused by the eddy current will degrade the quality factor (Q value) of the inductor. Thus, the invention provides a spiral inductor, in which the opening is formed in the spiral conductive trace pattern to divide the spiral conductive trace pattern into two parts. The magnetic fields which are generated by the two parts, cancelled each other out to avoid eddy current. Thus, the current of the spiral conductive trace pattern is uniformly distributed, and quality factor of the inductor (Q value) is improved.

For example, referring to FIG. 2B, when designing the position of the opening 300, the two adjacent spiral conductive trace patterns are divided into four parts 210, 220, 230, 240 from left to right, respectively. When the second part 220 is centered, the magnetic fields generated by the left side 210 and the right side 230, cancel each other out. When the first part 230 is centered, the magnetic field generated by the left side 220 and the right side 240 cancel each other out. Thus, preventing an unwanted eddy current. Regarding the design of the position of the opening, according to Lenz's Law and Ampere's Law, the width Wₘ of the spiral conductive trace pattern, the pitches P between neighboring turns of the spiral conductive trace pattern, the width S of the opening, the width W_{1a,1b} of the first part and the width W_{2a,2b} of the second part may be designed by those skilled in the art by computer simulated calculations to cancel the magnetic fields generated from the left and right sides of the divided spiral conductive trace pattern and further eliminate eddy current.

The width (W_{1a,1b}) of the first part 210, 230 may be larger than, equal to or smaller than the width (W_{2a,2b}) of the second part 220, 240. In one embodiment, referring to FIG. 2B, the width (W_{1a,1b}) of the first part 210, 230 is smaller than the width (W_{2a,2b}) of the second part 220, 240. However, the widths of the first part or the second part are not limited to a specific size. As long as the magnetic field of the divided spiral conductive trace pattern cancels each other out, other sizes of the width are within the scope of the invention.

The invention also provides a method for fabricating an electronic device. The method comprises the following steps. A substrate is firstly provided and the material of the substrate is described above, so repeated description is omitted. Then, a conductive trace pattern is formed on the substrate, wherein the conductive trace pattern has an opening to expose the substrate. The conductive trace pattern with the opening is formed by coating a photoresist on the substrate, applying a photolithography technique (known to those skilled in the art), forming a specific pattern on the substrate, applying a deposition process (such as chemical deposition method or sputter method) to form the conductive trace pattern, and then removing the photoresist.

The invention also provides a method for fabricating a spiral conductive trace inductor. A substrate is firstly provided and a spiral conductive trace pattern is formed on the substrate, wherein the spiral conductive trace pattern has at least one turn and an opening to expose the substrate. The method for forming the spiral conductive trace pattern with the opening is the same as that of the above embodiments, so, repeated description is omitted.

The invention provides an electronic device and a spiral inductor device, in which an opening is formed in the conductive trace pattern. When current flows through the electronic device or the spiral inductor device, the magnetic field of the conductive trace pattern or the spiral conductive trace pattern is changed by the design of the opening to avoid an eddy current. Therefore, the performance of the electronic device and the quality factor (Q value) of the spiral inductor device are improved.

### [Embodiment]

### Comparative embodiment

In the **comparative embodiment**, the width Wₘ of the spiral conductive trace pattern is about 25 µm and the spiral conductive trace pattern has 2.5 turns. The pitch P between neighboring turns of the spiral conductive trace pattern is about 3 µm. Note that there is no opening in the spiral conductive trace pattern.

### Embodiment 1

In the **embodiment 1**, the width Wₘ of the spiral conductive trace pattern was about 25 µm and the spiral conductive trace pattern had 2.5 turns. The pitch P between neighboring turns of the spiral conductive trace pattern was about 3 µm. The width S of the opening was about 6 µm, the width W_{1a,1b} of the first part was about 6.5 µm and the width W_{2a,2b} of the second part was about 12.5 µm.

According to a computer calculated data, the quality factor of the **embodiment 1** was higher than the **comparative embodiment** by about 25 %.

### Embodiment 2

In the **embodiment 2**, the width Wₘ of the spiral conductive trace pattern was about 25 µm and the spiral conductive trace pattern had 3.5 turns. The pitch P between neighboring turns of the spiral conductive trace pattern was about 2 µm. The width S of the opening was about 6 µm, the width W_{1a,1b} of the first part was about 6.5 µm and the width W_{2a,2b} of the second part was about 12.5 µm.

While the invention has been described by way of example and in terms of the preferred embodiments, it is to be understood that the invention is not limited to the disclosed embodiments. To the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. An electronic device, comprising:
a substrate (10); and
a conductive trace pattern (20) formed on the substrate, wherein the conductive trace pattern has an opening (30) to expose the substrate.

2. The electronic device as claimed in claim 1, wherein the opening is formed along the conductive trace pattern.

3. The electronic device as claimed in claims 1 or 2, wherein a length of the opening is smaller than a length of the conductive trace pattern.

4. The electronic device as claimed in claims 1-2 or 3, wherein the conductive trace pattern is divided into a first part and a second part by the opening.

5. The electronic device as claimed in claim 4, wherein a width of the first part is larger, equal to or smaller than a width of the second part.

6. The electronic device as claimed in one or more of the claims 1 to 5, wherein the conductive trace pattern comprises an arc shape or a rectangular shape.

7. The electronic device as claimed in one or more of the claims 1 to 6, wherein the conductive trace pattern is a spiral conductive trace.

8. The electronic device as claimed in one or more of the claims 1 to 7,
wherein the electronic device is a transmission line.

9. The electronic device as claimed in one or more of the claims 1 to 8,
wherein the electronic device is an energy storage device.

10. The electronic device as claimed in one or more of the claims 1 to 9,
wherein the opening comprises a continuous structure or a discontinuous structure.

11. The electronic device as claimed in claim 10, wherein the opening is divided into a plurality of sections to form the discontinuous structure.

12. A spiral inductor device, comprising:
a substrate (100); and
a spiral conductive trace pattern (200) formed on the substrate, wherein the spiral conductive trace pattern has at least one turn and an opening (300) to expose the substrate.

13. The electronic device as claimed in claim 12, wherein the opening is formed along the spiral conductive trace pattern.

14. The electronic device as claimed in one or more of the claims 12 to 13,
wherein a length of the opening is smaller than a length of the spiral conductive trace pattern.

15. The electronic device as claimed in one or more of the claims 12 to 14,
wherein the opening comprises a continuous structure or a discontinuous structure.

16. The electronic device as claimed in claim 15, wherein the opening is divided into a plurality of sections to form the discontinuous structure.

17. A method for fabricating an electronic device, comprising:
providing a substrate; and
forming a conductive trace pattern on the substrate, wherein the conductive trace pattern has an opening to expose the substrate.

18. The method for fabricating the electronic device as claimed in claim 17, wherein the opening is formed along the conductive trace pattern.

19. The method for fabricating the electronic device as claimed in claim 17 or 18, wherein a length of the opening is smaller than a length of the conductive trace pattern.

20. A method for fabricating a spiral inductor device, comprising:
providing a substrate; and
forming a spiral conductive trace pattern on the substrate, wherein the spiral conductive pattern has an opening to expose the substrate.
